(19) Europäisches Patentamt

European Patent Office

Office européen des brevets

(11) **EP 1 233 299 A1**

(12) **DEMANDE DE BREVET EUROPEEN**

(43) Date de publication:
   **21.08.2002 Bulletin 2002/34**

(21) Numéro de dépôt: **02290296.9**

(22) Date de dépôt: **07.02.2002**

(51) Int Cl.⁷: **G02F 1/025**, G02F 1/01,
   G02B 6/28, H01S 5/026,
   H01S 5/062, H01L 27/15,
   H01L 31/02, H01L 29/737

(84) Etats contractants désignés:
   **AT BE CH CY DE DK ES FI FR GB GR IE IT LI LU
   MC NL PT SE TR**
   Etats d'extension désignés:
   **AL LT LV MK RO SI**

(30) Priorité: **15.02.2001 FR 0102100**

(71) Demandeur: **ALCATEL**
   **75008 Paris (FR)**

(72) Inventeurs:
   • **Devaux, Fabrice**
     **92120 Montrouge (FR)**
   • **Blayac, Sylvian**
     **75013 Paris (FR)**
   • **Andre, Philippe**
     **92350 Le Plessis Robinson (FR)**

(74) Mandataire: **Fournier, Michel Robert Marie et al**
   **COMPAGNIE FINANCIERE ALCATEL**
   **Dépt. Propriété Industrielle,**
   **30, avenue Kléber**
   **75116 Paris (FR)**

(54) **Composant optique intégré monolithique comportant un modulateur et un transistor bipolaire à hétérojonction**

(57)   L'invention concerne un composant optique intégré monolithique comprenant un transistor de commande (10) connecté à un composant électro-optique (20) comportant un guide d'onde actif (25) et au moins un guide d'onde d'entrée et un guide d'onde de sortie, caractérisé en ce que ledit transistor (10) est un transistor bipolaire à hétérojonction (HBT) comportant au moins une couche de sous-collecteur (SC) qui est commune à une couche de confinement (21) du composant électro-optique (20), et en ce que le guide d'onde actif (25) dudit composant électro-optique (20) comporte une structure élargie (30) située sous une zone de contact du transistor bipolaire à hétérojonction (10) et présentant sensiblement la même surface que ledit transistor (10).

Fig. 1

**Description**

L'invention concerne le domaine des composants électroniques et électro-optiques réalisés sur des matériaux à structure cristalline (matériaux III-V par exemple) et destinés à être utilisés dans le cadre d'applications de transmission de données à haut débit sur fibres optiques.

L'invention concerne plus spécifiquement un composant optique monolithique intégré comportant un élément électronique et un élément électro-optique, tel qu'un transistor connecté à un modulateur pour une commande en tension de ce dernier.

La présente invention cherche à améliorer les performances de l'ensemble constitué par ces deux éléments électronique et électro-optique.

Un modulateur électro-optique classique comporte un empilement de couches épitaxiées sur un substrat en matériau semi-conducteur III-V, généralement de l'InP. Les couches successives sont constituées d'une couche de confinement inférieure, d'une couche active, et d'une couche de confinement supérieure, ces trois couches formant le guide d'onde actif du composant. En général, la couche active est composée d'un matériau quaternaire unique non dopé, par exemple du InGaAsP. Les couches de confinement sont composées d'un matériau III-V, de l'InP par exemple, dopée chacune d'un type de porteurs différents et formant l'une l'anode et l'autre la cathode.

Le modulateur est généralement commandé par une source en tension, un transistor par exemple, dont l'impédance peut atteindre 50 Ohms. La fréquence de coupure résultante est alors donnée par la relation :

$$f_c = 1 / (2\pi(R_S+R_L)C_m).$$

Avec $R_S \approx 5\Omega$, la résistance de série du modulateur

     $R_L$, l'impédance de la source de commande
     $C_m$, la capacité du modulateur.

Il en résulte que le modulateur n'est pas utilisé au meilleur de ses performances et que la largeur de la bande de fréquence de fonctionnement d'un modulateur électro-optique sur InP est 5 à 10 fois inférieure à celle imposée par les limites intrinsèques au matériau. Cela est particulièrement nuisible dans le cadre d'applications haut débit avec des modulateurs fonctionnant entre 40 et 160 Gb/s.

Afin de réduire l'impédance de la source de commande, il a été envisagé de réduire au maximum, voire de supprimer, les transports de charges électriques entre la source et le modulateur. Cela a été tenté en rapprochant physiquement les deux éléments. Cependant, cette solution ne permet pas d'éviter totalement les parasites entre la source et le modulateur. Or, un Ohm de résistance parasite peut entraîner une réduction de la bande passante en dessous de 40 GHz.

Une autre solution, proposée dans l'art antérieur, consiste à réaliser une intégration monolithique du modulateur avec le transistor de commande en intégrant la couche active du modulateur dans la structure du transistor (dans la couche de collecteur).

Une telle solution comporte cependant des inconvénients. La couche active du modulateur est située dans la zone de déplétion du collecteur, ce qui, en schéma équivalent, consiste à placer le modulateur en série du collecteur. Comme il n'y a alors plus accès à une des couches du modulateur, la commande est réalisée en courant et non plus en tension. Une telle commande en courant implique une forte résistance de charge, qui peut même être supérieure à 50Ω. La largeur de la bande passante du modulateur n'est donc pas améliorée.

Le but de la présente invention est de proposer une intégration du composant électro-optique avec l'élément électrique de commande de manière à minimiser les résistances parasites et à permettre le fonctionnement optimal dudit composant électro-optique.

A cet effet, l'invention propose d'utiliser un transistor bipolaire à hétérojonction (HBT) comme source de commande en tension et de réaliser une intégration monolithique du composant électro-optique audit transistor HBT.

Selon la présente invention, l'intégration du composant électro-optique se situe dans la couche de sous-collecteur du transistor HBT qui constitue avantageusement une des couche de confinement dudit composant.

A cet effet, la structure active du composant électro-optique doit être élargie pour que la couche de sous-collecteur constitue directement la couche supérieure de confinement dudit composant. La taille du transistor ne pouvant pas être réduite en deçà d'une valeur limite imposée par les contraintes de fabrication et de conception, c'est la largeur du composant électro-optique qui doit être augmentée.

Cependant, un élargissement du guide d'onde actif du composant électro-optique entraîne la perte de la propagation monomode du signal dans ledit composant. L'invention propose par conséquent d'allonger la zone élargie du guide d'onde actif du composant, zone située sous le transistor HBT, afin de transformer cette zone élargie en un coupleur à interférence multimode comportant un guide d'onde d'entrée et un guide d'onde de sortie monomodes.

L'invention a plus particulièrement pour objet un composant optique intégré monolithique comprenant un transistor de commande connecté à un composant électro-optique comportant un guide d'onde actif et au moins un guide d'onde d'entrée et un guide d'onde de sortie, caractérisé en ce que ledit transistor est un transistor bipolaire à hétérojonction (HBT) comportant au moins une couche de sous-collecteur qui est commune à une couche de confinement du composant électro-optique, et en ce que le guide d'onde actif dudit composant électro-optique comporte une structure élargie située sous une zone de contact du transistor (HBT) et présentant sensiblement la même surface que ledit transistor.

Selon une caractéristique, la structure élargie du guide d'onde actif est allongée de manière à constituer un coupleur à interférence multimode (MMIC).

Les particularités et avantages de l'invention apparaîtront clairement à la lecture de la description qui suit, faite à titre d'exemple illustratif et non limitatif et en regard aux figures annexées sur lesquels :

　　la figure 1 illustre schématiquement l'empilement de couches épitaxiées du composant optique intégré monolithique selon l'invention.
　　la figure 2 est une vue schématique de dessus du composant selon l'invention.

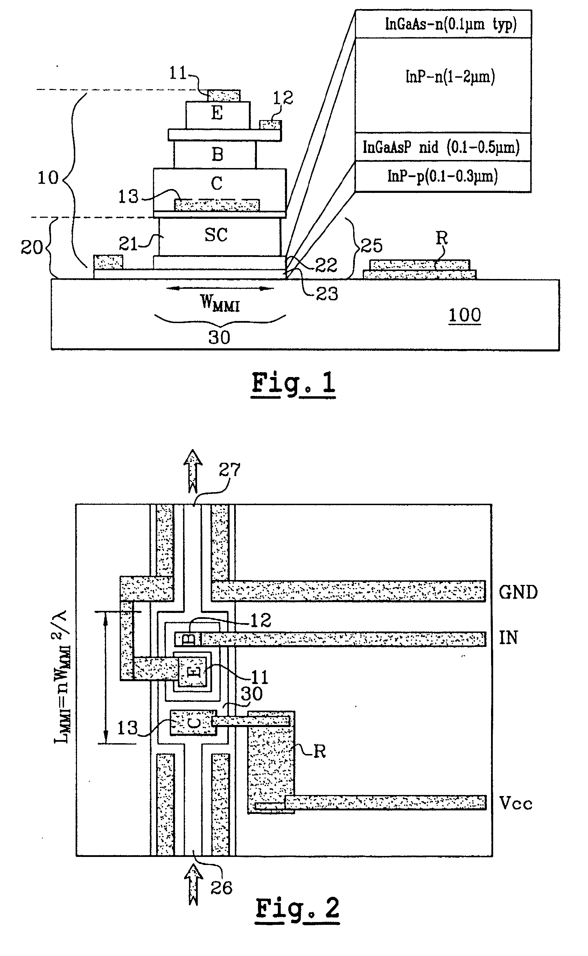

La présente invention cherche à réduire l'impédance de la source de commande d'un composant électro-optique. A cet effet, l'invention propose d'intégrer ledit composant électro-optique à ladite source de commande constituée par un transistor bipolaire à hétérojonction (HBT). Cette intégration est bien illustrée sur le schéma de la figure 1.

Les transistors bipolaires à hétérojonction 10 (HBT) sont parfaitement bien maîtrisé dans l'état de la technique. Ils sont généralement constitués de plusieurs couches épitaxiées sur un substrat 100 en matériau semi-conducteur III-V, classiquement de l'InP. Les différentes couches épitaxiées sont gravées pour constituer des mesas qui définissent le collecteur C, la base B et l'émetteur E du transistor 10. Des contacts électriques 11,12,13 doivent être pris sur chacun des mesas par un dépôt de zones métallique (appelées également zones de contact).

Généralement l'hétérojonction se situe entre la base B et l'émetteur E, les couches correspondantes étant réalisées dans des matériaux semi-conducteurs différents. Par exemple, une couche de base B en InGaAs et une couche d'émetteur E en InP dopée chacune d'un type différent. L'hétérojonction autorise des dopages de la base très élevés et permet la réalisation d'une base très fine. On obtient ainsi des fréquences de fonctionnement très élevées.

Selon les applications, un transistor bipolaire peut être à simple ou à double hétérojonction, la seconde hétérojonction se situant entre la base et le collecteur selon le même principe d'agencement de couche épitaxiées.

Eventuellement, la couche de collecteur C peut être déposée sur une couche intermédiaire de sous-collecteur SC et non directement sur le substrat 100. Le sous-collecteur SC est constitué d'un matériau semi-conducteur différent de celui du collecteur mais dopé du même type. Le contact métallique 13 du collecteur C est alors pris sur la couche de sous-collecteur SC.

Selon une caractéristique essentielle de l'invention, le composant électro-optique 20 est placé en dessous du transistor 10 de commande, la couche de sous-collecteur SC dudit transistor 10 étant utilisée pour constituer la couche supérieure de confinement 21 dudit composant 20.

Dans l'exemple de la figure 1, le composant électro-optique 20 est un modulateur dont le guide d'onde actif 25 est constitué d'une couche de confinement supérieure 21, d'une couche active 22 et d'une couche de confinement inférieure 23 déposées sur le substrat 100.

Selon d'autres applications de l'invention, le composant électro-optique peut être, par exemple, une source laser, une photodiode, un amplificateur optique en semi-conducteur ou autre.

Afin de permettre la mise en oeuvre de l'invention, le guide d'onde actif 25 du composant électro-optique 20 doit être élargi pour que la couche de sous-collecteur SC du transistor HBT 10 constitue directement la couche de confinement supérieure 21 dudit composant 20.

En effet, classiquement, la largeur d'un guide d'onde actif est largement plus petite que celle d'un transistor (environ dix fois plus petite). Or, la taille du transistor HBT 10 ne peut pas être réduite en deçà d'une valeur limite. C'est donc la largeur du composant électro-optique 20 qui doit être augmentée.

Ainsi, le guide d'onde actif 25 du composant électro-optique 20 comporte une structure élargie 30 située sous la zone de contact 13 du transistor HBT 10 et présentant sensiblement la même surface que la couche de sous collecteur SC dudit transistor 10.

Cependant, un élargissement du guide d'onde actif 25 entraîne la perte de la propagation monomode du signal dans le composant électro-optique 20. L'invention propose alors d'allonger la structure élargie 30 du composant électro-optique 20 afin de la transformer en un coupleur à interférence multimode (MMIC) comportant au moins un guide d'onde d'entrée 26 et un guide d'onde de sortie 27 monomodes (MMIC 1x1). Un tel allongement de la structure élargie 30 du composant électro-optique 20 implique nécessairement un allongement de la couche de sous-collecteur SC du transistor 10, mais cela ne nuit aucunement au bon fonctionnement dudit transistor HBT.

En se référant à la figure 2, la longueur $L_{MMI}$ de la structure élargie 30 du composant électro-optique 20 est reliée directement à sa largeur $W_{MMI}$ selon la relation suivante :

$$L_{MMI} = n \, W_{MMI}^{2} / \lambda$$

Avec n l'indice effectif du guide d'onde 25, et λ la longueur d'onde du signal optique se propageant dans le composant électro-optique 20.

Sans sortir du cadre de l'invention, on peut envisager d'appliquer l'intégration du composant électro-optique avec un transistor HBT dans un cas où ledit composant aurait N guides d'onde d'entrée et N guides d'onde de sortie monomodes.

La réalisation de l'invention fait appel à des procédés de fabrication connus et bien maîtrisés dans l'état de la technique.

Le composant électro-optique 20 et le transistor bipolaire à hétérojonction 10 sont intégrés sur un substrat 100, en InP semi-isolant par exemple. L'intégration est réalisée par un empilement de couches successives déposées par épitaxie selon des procédés bien connus permettant un bon contrôle des épaisseurs et des compositions de chaque couche épitaxiée. Cet empilement de couches successives est bien explicité par la figure 1.

L'invention permet avantageusement de réduire la résistance série entre le composant électro-optique 20 et le transistor de commande 10 en éliminant les résistances parasites liées aux contacts métalliques entre les deux éléments. En pratique, une résistance série de 3Ω a pu être obtenue. Avec une résistance série aussi faible, le modulateur 20 peut être commandé par une source d'impédance de 10Ω. La largeur de la bande passante peut ainsi être augmentée d'un facteur 2 à 3 par rapport à la largeur actuelle, tous les autres paramètres étant maintenus identiques. Les limites intrinsèques du composant peuvent donc être approchées davantage.

L'intégration du composant électro-optique au transistor de commande entraîne une dissipation thermique qui peut nuire aux performances dudit composant. En outre, un coupleur MMI induit environ 1dB de pertes optiques. Ces inconvénients sont cependant négligeables en regard des améliorations apportées par la présente invention.

## Revendications

1. Composant optique intégré monolithique comprenant un transistor de commande (10) connecté à un composant électro-optique (20) comportant un guide d'onde actif (25) et au moins un guide d'onde d'entrée (26) et un guide d'onde de sortie (27), **caractérisé en ce que** ledit transistor (10) est un transistor bipolaire à hétérojonction (HBT) comportant au moins une couche de sous-collecteur (SC) qui est commune à une couche de confinement (21) du composant électro-optique (20), et **en ce que** le guide d'onde actif (25) dudit composant électro-optique (20) comporte une structure élargie (30) située sous une zone de contact du transistor bipolaire à hétérojonction (10) et présentant sensiblement la même surface que ledit transistor (10).

2. Composant optique selon la revendication 1, **caractérisé en ce que** la structure élargie (30) du guide d'onde actif (25) est allongée de manière à constituer un coupleur à interférence multimode (MMIC).

3. Composant optique selon la revendications 2, **caractérisé en ce que** le coupleur à interférence multimode (MMIC) est un coupleur à un guide d'onde d'entrée et un guide d'onde de sortie (MMIC 1x1).

4. Composant optique selon la revendications 2, **caractérisé en ce que** le coupleur à interférence multimode (MMIC) est un coupleur à N guides d'onde d'entrée et N guides d'onde de sortie (MMIC NxN).

5. Composant optique selon l'une quelconque des revendications 1 à 4, **caractérisé en ce que** le composant électro-optique est un modulateur.

6. Composant optique selon l'une quelconque des revendications 1 à 4, **caractérisé en ce que** le composant électro-optique est une source laser.

7. Composant optique selon l'une quelconque des revendications 1 à 4, **caractérisé en ce que** le composant électro-optique est une photodiode.

8. Composant optique selon l'une quelconque des revendications 1 à 4, **caractérisé en ce que** le composant électro-optique est un amplificateur optique en semi-conducteur.

InGaAs-n(0.1µm typ)

InP-n(1-2µm)

InGaAsP nid (0.1-0.5µm)

InP-p(0.1-0.3µm)

11

12

E

B

C

13

10

SC

20

21

22

23

25

R

$W_{MMI}$

100

30

## Fig. 1

27

$L_{MMI} = nW_{MMI}^2/\lambda$

GND

12

IN

B

E

11

30

13

C

R

Vcc

26

## Fig. 2

**Office européen**
**des brevets**

## RAPPORT DE RECHERCHE EUROPEENNE

Numéro de la demande

EP 02 29 0296

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | YU-HENG JAN ET AL: "VERTICAL MONOLITHIC INTEGRATION OF A GAAS/ALGAAS V-CHANNELED SUBSTRATE INNER STRIPE LASER DIODE AND A HETEROJUNCTION BIPOLAR TRANSISTOR" APPLIED PHYSICS LETTERS, AMERICAN INSTITUTE OF PHYSICS. NEW YORK, US, vol. 57, no. 26, 24 décembre 1990 (1990-12-24), pages 2750-2752, XP000222929 ISSN: 0003-6951 * le document en entier * | 1,6 | G02F1/025 G02F1/01 G02B6/28 H01S5/026 H01S5/062 H01L27/15 H01L31/02 H01L29/737 |
| A | PATENT ABSTRACTS OF JAPAN vol. 007, no. 267 (E-213), 29 novembre 1983 (1983-11-29) -& JP 58 151087 A (NIPPON DENSHIN DENWA KOSHA), 8 septembre 1983 (1983-09-08) * abrégé * | 1,6 | |
| A | FR 2 663 161 A (THOMSON CSF) 13 décembre 1991 (1991-12-13) * le document en entier * | 1,5,6,8 | |
| | | | **DOMAINES TECHNIQUES RECHERCHES (Int.Cl.7)** |
| A | YOSHITAKA OKADA ET AL: "OPTICAL INTENSITY MODULATOR FOR INTEGRATED OPTICS BY USE OF A HETEROJUNCTION BIPOLAR TRANSISTOR WAVEGUIDE STRUCTURE" APPLIED PHYSICS LETTERS, AMERICAN INSTITUTE OF PHYSICS. NEW YORK, US, vol. 55, no. 25, 18 décembre 1989 (1989-12-18), pages 2591-2593, XP000126806 ISSN: 0003-6951 * page 2591; figure 1 * | 1,6 | G02F G02B H01S H01L |

-/--

Le présent rapport a été établi pour toutes les revendications

| Lieu de la recherche | Date d'achèvement de la recherche | Examinateur |
|---|---|---|
| LA HAYE | 10 avril 2002 | Stang, I |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**Office européen des brevets**

# RAPPORT DE RECHERCHE EUROPEENNE

Numéro de la demande

EP 02 29 0296

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | FR 2 768 524 A (FRANCE TELECOM) 19 mars 1999 (1999-03-19) * page 1, ligne 5 - ligne 9 * * page 3, ligne 14 - page 8, ligne 20; figures 3,5 * | 1-4,8 | |
| A | SILVA M T C ET AL: "GROWTH OPTIMIZATION FOR P-N JUNCTION PLACEMENT IN THE INTEGRATION OF HETEROJUNCTION BIPOLAR TRANSISTORS AND QUANTUM WELL MODULATORS ON INP" IEEE JOURNAL OF SELECTED TOPICS IN QUANTUM ELECTRONICS, IEEE SERVICE CENTER, US, vol. 6, no. 1, janvier 2000 (2000-01), pages 26-30, XP000908298 ISSN: 1077-260X * page 26, colonne de droite, ligne 34 - page 27, colonne de gauche, ligne 16; figure 1 * | 1,4 | |
| | | | DOMAINES TECHNIQUES RECHERCHES (Int.Cl.7) |

Le présent rapport a été établi pour toutes les revendications

| Lieu de la recherche | Date d'achèvement de la recherche | Examinateur |
|---|---|---|
| LA HAYE | 10 avril 2002 | Stang, I |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

**EP 1 233 299 A1**

**ANNEXE AU RAPPORT DE RECHERCHE EUROPEENNE
RELATIF A LA DEMANDE DE BREVET EUROPEEN NO.**

EP 02 29 0296

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-04-2002

| Document brevet cité au rapport de recherche | | Date de publication | Membre(s) de la famille de brevet(s) | | Date de publication |
|---|---|---|---|---|---|
| JP 58151087 | A | 08-09-1983 | AUCUN | | |
| FR 2663161 | A | 13-12-1991 | FR | 2663161 A1 | 13-12-1991 |
| FR 2768524 | A | 19-03-1999 | FR | 2768524 A1 | 19-03-1999 |
| | | | EP | 1012644 A1 | 28-06-2000 |
| | | | WO | 9914623 A1 | 25-03-1999 |

Pour tout renseignement concernant cette annexe : voir Journal Officiel de l'Office européen des brevets, No. 12/82